# FASCICULE DE BREVET EUROPEEN

(11) **EP 0 734 462 B1**
(45) Date de publication et mention de la délivrance du brevet: **21.04.1999**
(21) Numéro de dépôt: 95902838.2
(22) Date de dépôt: 07.12.1994
(51) Int. Cl.: C23C 16/44, C23C 16/50

(54) **PROCEDE ET APPAREIL DE FORMATION DE GAZ EXCITE**
VERFAHREN UND VORRICHTUNG ZUR HERSTELLUNG ANGEREGTER GASE
PROCESS AND APPARATUS FOR FORMING AN EXCITED GAS

(30) Priorité: 15.12.1993 FR 9315109
(43) Date de publication de la demande: 02.10.1996
(73) Titulaire: L'AIR LIQUIDE, SOCIETE ANONYME POUR L'ETUDE ET L'EXPLOITATION DES PROCEDES GEORGES CLAUDE, 75321 Paris Cédex 07 (FR)
(72) Inventeur: SINDZINGRE, Thierry, F-94230 Cachan (FR); RABIA, Stephane, 14 résidence du Parc du Château, F-91190 Gif-sur-Yvette (FR)
(74) Mandataire: Vesin, Jacques
(86) Numéro de dépôt international: FR9401423
(87) Numéro de publication internationale: WO9516802

(56) Documents cités:
- EP-A- 0 513 634
- US-A- 4 774 062
- US-A- 4 951 602

## Description

La présente invention concerne les dépôts de films contenant du silicium (par exemple les oxydes de silicium tels que la silice, ou encore les oxynitrures de silicium SiOxNy) effectués sur des surfaces métalliques (telles que des tôles), dans le but par exemple de leur apporter une coloration pour des raisons esthétiques, ou pour leur apporter des propriétés d'anticorrosion.

Il existe aujourd'hui plusieurs techniques de dépôt permettant de réaliser de telles couches minces d'oxyde de silicium ou d'oxynitrure de silicium sur des tôles métalliques. Parmi ces techniques, on cite le plus couramment les réactions de dépôt en phase vapeur plus connues sous le nom générique de méthode CVD (Chemical Vapor Deposition).

Ces méthodes consistent à faire réagir un ou des précurseurs gazeux du silicium, par exemple du silane SiH₄ et un oxydant tel que l'oxygène sur la surface de la tôle que l'on a préalablement activée, le dépôt étant effectué à pression atmosphérique ou à pression réduite, à une température choisie selon les conditions de pression adoptées :
- lorsque le dépôt est effectué à pression atmosphérique, il est nécessaire de fortement activer thermiquement la surface, le dépôt s'effectuera donc à une température élevée, typiquement de l'ordre de 800 à 1000°C.
- lorsque le dépôt est effectué à basse pression, la température adoptée sera plus basse, typiquement située entre 250°C et 600°C selon que la CVD est assistée ou pas, par exemple par une décharge électrique dans le gaz.

Les procédés CVD permettant de travailler à basse température (comme il est souvent souhaitable de le faire), sont donc associés à des conditions de basse pression. De telles conditions de basse pression constituent incontestablement une contrainte et expliquent un moindre développement de ces techniques CVD dans le cas des tôles d'acier qui se présentent généralement sous la forme de grandes surfaces produites en grande quantité.

La mise en oeuvre de tels procédés à pression réduite représente par ailleurs un surcoût non négligeable, du fait du coût des équipements de vide et de la maintenance élevée qui leur est associée.

Dans ce contexte, la demanderesse a récemment proposé dans le document FR-A- 2,692,598 un procédé pour le dépôt d'une couche contenant du silicium sur un substrat métallique. Ce procédé permettait d'effectuer successivement ou de façon concomitante la préactivation de la surface métallique par décharge diélectrique, puis le dépôt d'une couche contenant du silicium par exposition de la surface ainsi preactivée à une atmosphère contenant un précurseur gazeux du silicium. Ce procédé était mis en oeuvre à pression atmosphérique ou proche de la pression atmosphérique.

Si ce procédé constitue indiscutablement une amélioration par rapport aux techniques existantes, la Demanderesse a mis en évidence le fait qu'il peut être amélioré, notamment en ce que :
- la distance entre l'échantillon à traiter et l'électrode (la tôle peut d'ailleurs constituer une des électrodes métalliques) est critique pour l'obtention d'un traitement parfaitement homogène, ce qui constitue une contrainte lorsqu'il est nécessaire de traiter en continu des tôles d'épaisseur variable.
- d'autre part, la mise en oeuvre du procédé nécessite que les substrats passent au sein de la décharge, d'où une source de pollution pour les électrodes du fait de la présence de poussières ou de particules grasses à la surface des substrats.
- lorsque le procédé réalise de façon concomitante la préactivation et le dépôt, le précurseur gazeux du silicium, tel le silane, est introduit directement dans la décharge, d'où le risque de déposer des poussières (poudre) de silice ou d'oxydes de silicium sur les électrodes, ce qui perturbe le fonctionnement de l'appareillage considéré.
- enfin, la configuration géométrique permettant la mise en oeuvre de ce procédé limitait la densité de puissance que l'on pouvait mettre en oeuvre, une augmentation de la densité de puissance au-delà de cette limite risquant d'entraîner une délocalisation du nuage ionisé.

Dans un contexte plus général, la demanderesse a, dans le document FR-A-2,692,730, dont le contenu est supposé intégré ici pour référence, récemment proposé un dispositif de formation de molécules gazeuses excitées ou instables, fonctionnant sensiblement à la pression atmosphérique, et permettant d'atteindre des densités énergétiques améliorées.

Dans ce contexte, la présente invention a pour objet de proposer un procédé amélioré pour former un dépôt d'un film contenant du silicium sur un substrat métallique, permettant :
- d'opérer sensiblement à pression atmosphérique,
- une grande flexibilité de distance entre l'objet à traiter et le dispositif utilisé pour effectuer ce traitement,
- d'offrir une densité énergétique améliorée, permettant d'atteindre une vitesse de traitement accrue,
- d'éviter que le précurseur gazeux du silicium utilisé ne soit mis en situation de donner lieu à des réactions à l'intérieur du dispositif en question (dépôt de poudres),
- d'éviter que le substrat sur lequel doit être effectué le dépôt n'ait à passer au sein de ce dispositif,
- de travailler si besoin est à basse température.

Pour ce faire, selon le procédé de l'invention on forme un dépôt d'un film contenant du silicium sur un substrat métallique avec un appareil de formation d'espèces gazeuses excitées ou instables, dans lequel un mélange gazeux initial est transformé en un mélange gazeux primaire, l'appareil étant le siège d'une décharge électrique créée entre une première électrode et une seconde électrode, qui s'étendent selon une direction principale allongée, le mélange gazeux initial traversant la décharge transversalement aux électrodes et à cette direction principale, le mélange gazeux primaire obtenu à la sortie de gaz de l'appareil, qui comprend des espèces gazeuses excitées ou instables et qui est substantiellement dépourvu d'espèces électriquement chargées, formant avec un mélange gazeux adjacent qui comprend au moins un précurseur gazeux du silicium et qui n'a pas transité par 1' appareil, l'atmosphère gazeuse de traitement qui est mise en contact avec le substrat pour réaliser le dépôt.

Une couche d'un matériau diélectrique est avantageusement disposée sur la surface d'au moins une des électrodes, en regard de l'autre électrode. L'énergie mise en oeuvre dans l'appareil, ramenée à l'unité de surface de diélectrique sera alors avantageusement supérieure à 1W/cm², préférentiellement supérieure à 10 W/cm².

La mise en contact de l'atmosphère gazeuse de traitement avec le substrat, pour réaliser le dépôt, est avantageusement effectuée à une pression voisine de la pression atmosphérique.

On entend par "pression voisine de la pression atmosphérique" selon l'invention, une pression se situant dans l'intervalle [0,1 x 10⁵ Pa, 3 x 10⁵ Pa].

On entend par surface métallique selon l'invention, tout type de surface sur laquelle il peut apparaître avantageux d'effectuer un dépôt d'une couche contenant du silicium, comme par exemple des tôles métalliques, qu'elles soient par exemple en acier, en acier inoxydable, en cuivre, ou encore en aluminium, ou les alliages de tels éléments, quelque soit la dimension ou l'épaisseur de la pièce (ou produit) comportant la surface métallique à traiter, que ces produits soient plats (comme les tôles), ou creux tels que par exemple des bouteilles. Leur application industrielle finale peut être très variée, que ces surfaces métalliques soient par exemple utilisées dans le domaine de l'électroménager, de l'automobile, des gaz industriels ou encore dans l'industrie du bâtiment.

On entend par "précurseur gazeux du silicium", l'un des multiples gaz dont la molécule comporte du silicium, tel que par exemple le silane, le disilane etc..

Comme il apparaîtra clairement à l'homme du métier, l'atmosphère de traitement selon l'invention, utilisée pour réaliser le dépôt, est obtenue par la combinaison du mélange gazeux primaire obtenu en sortie d'un tel appareil de formation d'espèces gazeuses excitées ou instables, qui comprend donc de telles espèces gazeuses excitées ou instables, et du mélange gazeux adjacent, le mélange gazeux primaire transférant toute ou partie de son énergie au précurseur gazeux du silicium compris dans le mélange gazeux adjacent et à la surface du substrat à traiter, permettant ainsi le dépôt. Le précurseur gazeux du silicium n'ayant pas transité par l'appareil, le risque de formation de poudre de silice (ou plus généralement de composés du silicium) à l'intérieur de la décharge est de ce fait éliminé. Le substrat n'est par ailleurs en contact qu'avec la sortie de gaz de l'appareil considéré, il n'a pas "séjourné" dans l'appareil.

On peut qualifier cette configuration de "post-décharge" puisque la composante primaire de l'atmosphère de traitement, qui comprend des espèces gazeuses excitées ou instables, est obtenue en sortie d' appareil, ce qui assure l'absence substantielle de toute espèce électriquement chargée dans cette composante primaire. La composante adjacente de l'atmosphère de traitement, qui n'a pas transité par l'appareil, en est à fortiori dépourvue.

Par ailleurs, cette configuration permet de nettement séparer le lieu de la génération de la composante primaire de l'atmosphère du lieu de son utilisation, ce qui présente un avantage non négligeable en terme de pollution de l'appareil (éviter que les dégagements divers résultant de l'opération de dépôt n'aillent polluer l'intérieur de l'appareil, par exemple ses électrodes). Enfin, la pièce, qui n'est pas traitée au sein de l'appareil (par exemple au sein de la décharge entre les électrodes), bénéficie d'une bien meilleure flexibilité sur l'aspect "distance" évoqué plus haut.

Comme il apparaîtra aussi clairement à l'homme du métier, l'invention s'applique selon les besoins exprimés par l'utilisateur tant au traitement d'une seule des faces de la pièce à traiter, qu'au cas où l'on doit traiter la pièce sur ses deux faces. Dans ce dernier cas, il conviendra de disposer les appareils requis en regard de chaque face de la pièce.

La nature du composé du silicium déposé (SiOₓN_{y}, SiOₓ, voire SiOₓN_{y}H_{z}) sera étroitement liée aux conditions expérimentales utilisées, notamment aux pressions partielles d'oxygène et d'azote dans l'atmosphère de traitement. Il sera par exemple possible de contrôler la nature du film déposé en jouant notamment sur la nature du gaz inerte utilisé tant dans le mélange initial que dans le mélange adjacent, mais aussi sur la niveau de la pression partielle d'oxygène maintenue au sein de l'atmosphère de traitement.

Comme il apparaîtra aussi clairement à l'homme du métier, le substrat métallique à traiter pourra être mis en contact avec la sortie de gaz d'un seul appareil ou de plusieurs appareils placés en parallèle sur la largeur du substrat ou encore successivement avec les sorties de gaz de plusieurs appareils de formation d'espèces gazeuses excitées ou instables placés en série.

Le cas échéant, le substrat métallique à traiter aura au préalable subit une préparation (ou traitement) de surface selon une des multiples méthodes disponibles, que ce soit en phase liquide ou en phase gazeuse.

Selon une des mises en oeuvre de l'invention, le mélange gazeux initial comprend un gaz inerte et/ou un gaz réducteur et/ou un gaz oxydant. Le gaz inerte peut par exemple consister en de l'azote, de l'argon, de l'hélium ou un mélange de tels gaz inertes. Le gaz réducteur peut par exemple consister en de l'hydrogène, du CH₄ ou encore de l'ammoniac ou un mélange de tels gaz réducteurs. Le gaz oxydant peut quant à lui par exemple consister en de l'oxygène, ou du CO₂, ou encore du N₂O, H₂O, ou un mélange de tels gaz oxydants. La liste de gaz donnés dans chaque catégorie n'étant bien entendu qu'indicative, nullement limitative.

Le mélange gazeux adjacent comprendra avantageusement, en dehors du ou des précurseurs gazeux du silicium, un gaz inerte et/ou un gaz réducteur, et comprendra le cas échéant un gaz oxydant.

Selon une autre mise en oeuvre de l'invention, le précurseur gazeux du silicium du mélange gazeux adjacent est du monosilane SiH₄.

Selon un des aspects de l'invention, le substrat métallique à traiter est porté à une température comprise entre la température ambiante et 400°C.

Selon une des mises en oeuvre de l'invention, le substrat métallique à traiter est amené en regard de la sortie de gaz d'un appareil de formation d'espèces gazeuses excitées ou instables, le cas échéant, en regard des sorties de gaz de plusieurs appareils placés en parallèle sur la largeur du substrat et/ou successivement en regard des sorties de gaz de plusieurs appareils placés en série, par un système de convoyage traversant un espace intérieur délimité par un ensemble de capotage (par exemple un tunnel ou un ensemble de capotages élémentaires), isolé de l'atmosphère environnante; ledit ensemble étant raccordé de façon étanche audit appareil ou incluant le dit appareil.

Selon une des mises en oeuvre de l'invention, on réalise un zonage de l'atmosphère de traitement rencontrée successivement par la pièce à traiter le long du convoyeur, de la façon suivante :
a) au moins un des appareils de formation d'espèces gazeuses excitées ou instables, transforme un mélange gazeux initial différent de celui transformé par l'appareil le précédant dans le dit ensemble, et/ou
b) le mélange gazeux adjacent mis en oeuvre au niveau d'au moins un des appareils de formation d'espèces gazeuses excitées ou instables est différent de celui mis en oeuvre au niveau de l'appareil le précédant dans le dit ensemble.

Les étapes a) et b) ci-dessus pourront par exemple concerner un même appareil.

On pourra ainsi par exemple utiliser des mélanges de pouvoir réducteur croissant, d'un appareil à l'autre ou encore jouer sur ce paramètre "composition successive de l'atmosphère de traitement" pour réaliser des dépôts multicouches, chaque couche étant d'épaisseur et de structure différentes et contrôlées.

L'invention concerne aussi un dispositif convenant notamment pour la mise en oeuvre de l'invention, comprenant un ensemble de capotage définissant un espace intérieur traversé par des moyens de convoyage des substrats métalliques à traiter, isolé de l'atmosphère environnante, se raccordant de façon étanche ou incluant un ou plusieurs appareils de formation d'espèces gazeuses excitées ou instables, montés en série et/ou parallèle, comprenant au moins un passage de gaz tubulaire ayant un axe, formé entre une électrode extérieure et une électrode intérieure, l'une au moins des électrodes comportant, en regard de l'autre, un revêtement diélectrique, les électrodes étant reliées à une source haute tension et haute fréquence, l'électrode extérieure entourant le diélectrique et comportant une entrée de gaz dit initial et une sortie de gaz dit primaire allongées, parallèles à l'axe et sensiblement diamétralement opposées, ladite sortie de gaz débouchant à l'intérieur dudit ensemble, qui est muni d'au moins un moyen d'injection d'un gaz dit adjacent n'ayant pas transité par le ou les dits appareils.

Le dispositif comprenant de plus, le cas échéant, un moyen de chauffage des substrats métalliques à traiter.

On pourra par exemple envisager, pour ce moyen de chauffage, des lampes infra rouge présentes dans le tunnel ou ensemble de capotages, ou un chauffage par convection (parois chaudes du tunnel) ou encore le fait que la pièce soit posée sur un porte-substrat chauffant.

D'autres caractéristiques et avantages de la présente invention, ressortiront de la description suivante de modes de réalisation, donnés à titre illustratif mais nullement limitatif, faits en relation avec les dessins annexés sur lesquels :
- la figure 1 est une représentation schématique d'un dispositif simplifié convenant pour la mise en oeuvre de l'invention.
- la figure 2 est une représentation schématique d'un mode de réalisation de l'invention comprenant un tunnel.
- la figure 3 est une représentation schématique en section d'un appareil de formation d'espèces gazeuses instables ou excitées convenant pour la mise en oeuvre de l'invention.

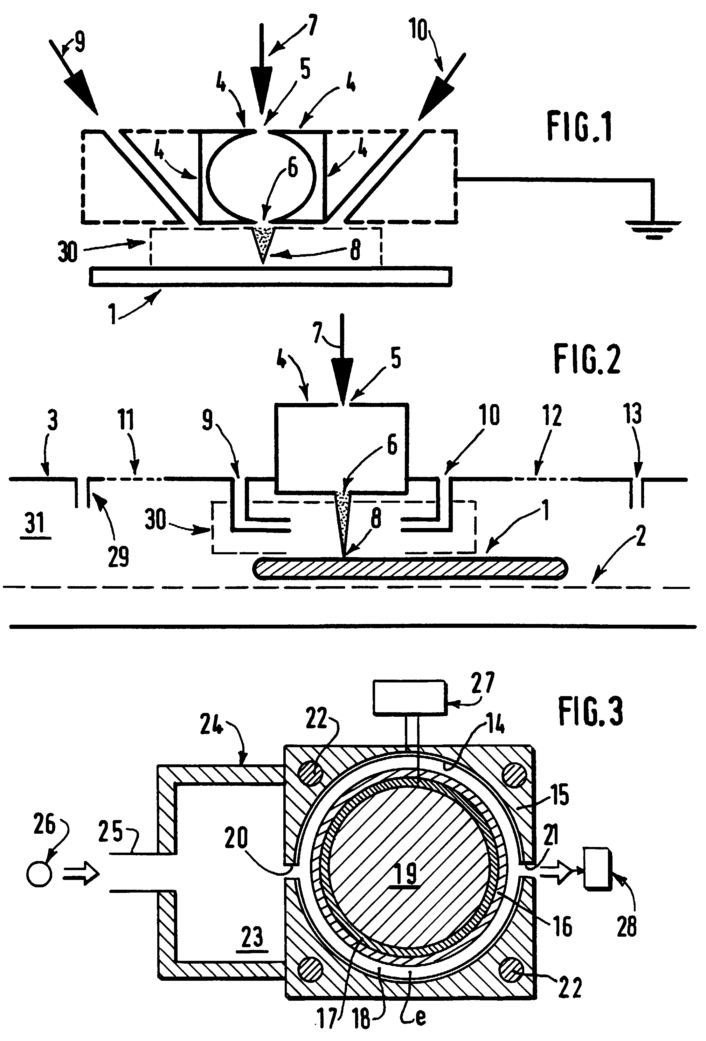

Est schématisé, sur la figure 1 en 4, un appareil de formation d'espèces gazeuses instables ou excitées, alimenté en son entrée de gaz 5 par un mélange gazeux initial 7. Est obtenu en sortie de gaz 6, un mélange gazeux primaire 8. Un substrat métallique 1 placé en regard de cette sortie de gaz 6 voit par ailleurs un mélange adjacent qui arrive, sur le mode de réalisation représenté, par deux entrées de gaz 9, 10, ce mélange adjacent ne transitant pas par l'appareil de formation d'espèces gazeuses excitées ou instables 4.

On a symbolisé sur cette figure 1, par le rectangle en tirets 30, la zone où interagissent les mélanges de gaz primaire et adjacent de façon à réaliser le dépôt contenant du silicium sur le substrat métallique 1.

On reconnaît sur la figure 2, qui est un mode de réalisation particulier de l'invention, un tunnel 3 délimitant un espace intérieur 31, dans lequel est convoyé le substrat métallique 1, grâce à un moyen de convoyage 2.

Le substrat métallique 1 est amené en regard de la sortie de gaz 6 d'un appareil de formation d'espèces gazeuses excitées ou instables 4 où il entre en contact avec le mélange gazeux primaire 8 obtenu à partir du mélange initial 7 et avec le mélange adjacent qui entre par des entrées de gaz 9 et 10, ce mélange adjacent n'ayant lui pas transité par l'appareil 4.

Ici encore, on a schématisé par le rectangle en tirets 30, la zone d'interaction entre le mélange gazeux primaire 8 et le mélange adjacent arrivant par les entrées de gaz 9 et 10.

Le mode de réalisation représenté sur la figure 2 permet de traiter le substrat métallique 1 par plusieurs appareils de formation d'espèces gazeuses instables ou excitées placés en série, les appareils placés en 11 et 12 n'ayant pas été représentés, le numéro 13 illustre un exemple d'entrée supplémentaire de mélange adjacent.

L'installation est par ailleurs pourvue, le cas échéant, d'un moyen de chauffage de la pièce 1, non représenté sur la figure 2. Comme signalé plus haut, on pourra par exemple envisager, pour ce moyen de chauffage, des lampes infra rouge présentes dans le tunnel, ou un chauffage par convection (parois chaudes du tunnel) ou encore le fait que la pièce soit posée sur un porte-substrat chauffant.

On reconnaît sur la figure 3, qui représente schématiquement une section d'un appareil de formation d'espèces gazeuses excitées ou instables convenant pour la mise en oeuvre de l'invention (qui est pour ce mode de réalisation de géométrie cylindrique), une première électrode tubulaire 14 formée par exemple par une face interne d'un bloc métallique 15, et dans laquelle est disposé, concentriquement, un ensemble d'un tube en matériau diélectrique 16, par exemple en céramique, sur la face interne duquel est déposée, par métallisation, une deuxième électrode 17 (exagérément épaissie sur la figure 3 pour une meilleure compréhension).

L'ensemble du diélectrique 16 et de la deuxième électrode 17 définis ainsi avec la première électrode 14, un passage tubulaire de gaz 18, et intérieurement, un volume interne 19 dans lequel on fait circuler un réfrigérant, avantageusement un Fréon pour son caractère électronégatif ou encore de l'eau permutée.

Le passage de gaz interne 18 a une extension axiale inférieure à 1 m, typiquement inférieure à 50 cm, et son épaisseur radiale e n'excède pas 3 mm et est typiquement inférieure à 2,5 mm. Le bloc 15 comporte diamétralement opposées, deux fentes longitudinales 20 et 21, formant respectivement l'entrée du gaz initial à exciter dans le passage 18 et la sortie du flux de gaz primaire comportant des espèces excitées ou instables.

Les fentes 20 et 21 s'étendent sur toute la longueur axiale de la cavité 18 et ont, pour le mode de réalisation représenté, une hauteur qui n'excède pas l'épaisseur e et est typiquement sensiblement identique à cette dernière.

Le corps 15 est formé avantageusement, à la périphérie de la première électrode 14, avec une pluralité de conduits 22 pour le passage d'un réfrigérant, par exemple de l'eau.

L'entrée de gaz 20 communique avec une chambre ou plénum d'homogénéisation 23 formée dans un boîtier 24 accolé au bloc 15 et comportant une tubulure 25 d'amenée de mélange gazeux initial, à une pression comprise dans l'intervalle [0,1 x 10⁵ Pa, 3 x 10⁵ Pa] en provenance d'une source de mélange gazeux initial 26.

Les électrodes sont reliées à un générateur électrique haute tension et haute fréquence 27 fonctionnant à une fréquence supérieure à 15 kHz et délivrant une puissance par exemple de l'ordre de 10 kW. Comme signalé précédemment, on pourra d'ailleurs avantageusement exprimer cette puissance délivrée par le générateur en la ramenant à la surface de diélectrique (c'est à dire à l'unité de surface de l'électrode diélectrique).

Le flux gazeux contenant les espèces excitées disponible à la sortie 21 est adressé à un poste utilisateur 28, par exemple pour le dépôt d'une couche contenant du silicium sur un substrat métallique.

Une installation telle que celle décrite en relation avec la figure 2, comprenant un unique appareil 4 de formation d'espèces gazeuses excitées ou instables tel que celui décrit en relation avec la figure 3, a été utilisée pour réaliser des exemples de mises en oeuvre de l'invention.

Pour ce faire, des échantillons de tôle d'acier bas carbone de dimensions 10 cm x 10 cm x 0,2 mm, ont été au préalable prétraités, de façon à réaliser leur nettoyage et leur désoxydation avant de subir le procédé de dépôt selon l'invention.

Selon un premier exemple de mise en oeuvre, le dépôt a été effectué dans les conditions suivantes :
- l'échantillon de tôle n'était pas chauffé, une température d'environ 50°C étant assurée par le simple contact avec le mélange gazeux primaire,
- la densité d'énergie mise en oeuvre sur le diélectrique était de l'ordre de 15 W/cm²,
- le mélange gazeux initial était un mélange azote/hydrogène à 23 % d'hydrogène obtenu par des débits respectifs de 10 m³/h d'azote et 3 m³/h d'hydrogène,
- le mélange gazeux adjacent, ne transitant pas par l'appareil de formation d'espèces gazeuses excitées ou instables, était constitué par un débit de 0,5 l/mn d'une source initiale à 2% de silane dans l'argon.
- la pression maintenue dans le tunnel était voisine de la pression atmosphérique.

Chaque échantillon ainsi traité, au défilé (2 mm/s) en un passage, a ainsi reçu un dépôt d'environ 1.000 Å d'un alliage amorphe du silicium (comme contrôlé par spectroscopie infra-rouge).

L'observation du dépôt ainsi réalisé par microscopie électronique à balayage a permis de s'assurer que le dépôt était parfaitement continu et dense.

Dans un second exemple de mise en oeuvre, adoptant la même densité d'énergie, les mêmes conditions d'alimentation de la décharge en mélange gazeux initial, mais utilisant cette fois 5 litres/minute du mélange silane/argon à 2% de silane pour réaliser le mélange gazeux adjacent, et en procédant cette fois à une température de 200°C, il a été obtenu un dépôt de 5.000 Å d'un alliage amorphe du silicium sur l'échantillon d'acier bas carbone, ceci avec une vitesse de défilé de 1mm/s.

Ici encore l'observation du dépôt à l'aide de la microscopie électronique à balayage a permis de s'assurer que le dépôt obtenu était parfaitement continu et dense.

Les deux exemples précédents montrent qu'il est possible d'obtenir, à basse température (voire à température ambiante), selon l'invention, des dépôts de bonne qualité contenant du silicium, sur substrat métallique.

Quoique la présente invention ait été décrite en relation avec des modes de réalisation particuliers, elle ne s'en trouve pas limitée pour autant mais est au contraire susceptible de modifications et de variantes qui apparaîtront à l'homme de l'art, dans le cadre des revendications ci-après.

## Revendications

1. Procédé pour former un dépôt d'un film contenant du silicium sur un substrat métallique (1), selon lequel on dispose d'au moins un appareil (11, 4, 12) de formation d'espèces gazeuses excitées ou instables, dans lequel on transforme un mélange gazeux initial (7) en un mélange gazeux primaire (8), l'appareil étant le siège d'une décharge électrique créée entre une première électrode (14) et une seconde électrode (17), qui s'étendent selon une direction principale allongée, le mélange gazeux initial traversant la décharge transversalement aux électrodes et à cette direction principale, le mélange gazeux primaire (8) qui est obtenu à la sortie (6) de gaz dudit appareil, qui comprend des espèces gazeuses excitées ou instables et qui est substantiellement dépourvu d'espèces électriquement chargées, formant avec un mélange gazeux adjacent (9, 10), qui comprend au moins un précurseur gazeux du silicium et qui n'a pas transité par ledit appareil, l'atmosphère gazeuse de traitement (30) qui est mise en contact avec le substrat pour réaliser le dépôt.

2. Procédé selon la revendication 1, caractérisé en ce que la mise en contact de l'atmosphère gazeuse de traitement (30) avec le substrat est effectuée à une pression voisine de la pression atmosphérique.

3. Procédé selon l'une des revendications 1 ou 2, caractérisé en ce que une couche d'un matériau diélectrique, est disposée sur la surface d'au moins une des électrodes, en regard de l'autre électrode.

4. Procédé selon l'une des revendications 1 à 3, caractérisé en ce que le dit mélange gazeux initial comprend un gaz inerte et/ou un gaz réducteur et/ou un gaz oxydant.

5. Procédé selon l'une des revendications 1 à 4, caractérisé en ce que le dit mélange gazeux adjacent comprend, en plus du ou des précurseurs gazeux du silicium, un gaz inerte et/ou un gaz réducteur, et le cas échéant un gaz oxydant.

6. Procédé selon l'une des revendications 1 à 5, caractérisé en ce que le précurseur du silicium est le monosilane SiH₄.

7. Procédé selon l'une des revendications 1 à 6 caractérisé en ce que le substrat métallique est porté à une température comprise entre la température ambiante et 400°C.

8. Procédé selon l'une des revendications 1 à 7 caractérisé en ce que le substrat métallique à traiter est amené en regard de la sortie (6) de gaz du dit appareil (4), le cas échéant en regard des sorties de gaz de plusieurs appareils placés en parallèle sur la largeur du substrat et/ou successivement en regard des sorties de gaz de plusieurs appareils (11, 4, 12) placés en série, par un système de convoyage (2) traversant un espace intérieur (31) délimité par un ensemble (3) de capotage, isolé de l'atmosphère environnante, ledit ensemble étant raccordé de façon étanche audit appareil ou incluant le dit appareil.

9. Procédé selon la revendication 8, dans son rattachement à la revendication 3, caractérisé en ce que l'énergie mise en oeuvre dans le dit appareil, ramenée à l'unité de surface de diélectrique est supérieure à 1 W/cm², préférentiellement supérieure à 10 W/cm².

10. Procédé selon l'une des revendications 8 ou 9, caractérisé en ce que l'on réalise un zonage de l'atmosphère de traitement rencontrée successivement par le substrat à traiter le long du convoyeur, de la façon suivante :
a) au moins un des dits appareils de formation d'espèces gazeuses excitées ou instables transforme un mélange gazeux initial différent de celui transformé par l'appareil le précédant dans le dit ensemble, et/ou
b) le mélange gazeux adjacent mis en oeuvre au niveau d'au moins un des dits appareils de formation d'espèces gazeuses excitées ou instables est différent de celui mis en oeuvre au niveau de l'appareil le précédant dans le dit ensemble.

11. Procédé selon la revendication 10, caractérisé en ce que les étapes a) et b) ont lieu au niveau d'un même appareil.

12. Dispositif pour former un dépôt d'un film contenant du silicium sur un substrat métallique, convenant notamment pour la mise en oeuvre de l'une quelconques des revendications 1 à 11, comprenant un ensemble (3) de capotage définissant un espace intérieur (31) traversé par des moyens de convoyage (2) des substrats métalliques (1) à traiter, isolé de l'atmosphère environnante, se raccordant à ou incluant un ou plusieurs appareils (11, 4, 12) de formation d'espèces gazeuses excitées ou instables, montés en série et/ou parallèle, comprenant au moins un passage (18) de gaz tubulaire ayant un axe, formé entre une électrode extérieure (14) et une électrode intérieure (17), l'une au moins des électrodes comportant, en regard de l'autre, un revêtement diélectrique (16), les électrodes étant reliées à une source haute tension et haute fréquence, l'électrode extérieure (14) entourant le diélectrique (16) et comportant une entrée (20) de gaz initial et une sortie (21) de gaz primaire allongées, parallèles à l'axe et sensiblement diamétralement opposées, ladite sortie de gaz débouchant à l'intérieur dudit ensemble, qui est muni d'au moins un moyen d'injection (9, 10, 13) d'un gaz adjacent n'ayant pas transité par le ou les dits appareils.

## Patentansprüche

1. Verfahren zur Erzeugung einer Abscheidung eines Silicium enthaltenden Films auf einem Metallsubstrat (1), gemäß welchem über wenigstens ein Gerät (11,4,12) zur Herstellung von angeregten oder instabilen Gasarten verfügt wird, in dem ein Ausgangsgasgemisch (7) in ein Primärgasgemisch (8) umgewandelt wird, wobei das Gerät der Ort einer elektrischen Entladung ist, die zwischen einer ersten Elektrode (14) und einer zweiten Elektrode (17), die sich gemäß einer länglichen Hauptrichtung erstrecken, erzeugt wird, wobei das Ausgangsgasgemisch die Entladung quer zu den Elektroden und zu dieser Hauptrichtung durchströmt und das Primärgasgemisch (8), das am Gasauslaß (6) des Geräts erhalten wird, das angeregte oder instabile Gasarten enthält und das im wesentlichen frei von elektrisch geladenen Arten ist, mit einem angrenzenden Gasgemisch (9,10), das wenigstens eine gasförmige Silicium-Vorstufe enthält und das nicht durch das Gerät geleitet wurde, die Behandlungs-Gasatmosphäre (30) bildet, die mit dem Substrat in Kontakt gebracht wird, um die Abscheidung auszuführen.

2. Verfahren nach Anspruch 1, dadurch gekennzeichnet, daß der Kontakt der Behandlungs-Gasatmosphäre (30) mit dem Substrat bei einem Druck um den Atmosphärendruck erfolgt.

3. Verfahren nach einem der Ansprüche 1 oder 2, dadurch gekennzeichnet, daß eine Schicht aus einem dielektrischen Material auf der Oberfläche wenigstens einer der Elektroden gegenüber der anderen Elektrode angeordnet ist.

4. Verfahren nach einem der Ansprüche 1 bis 3, dadurch gekennzeichnet, daß das Ausgangsgasgemisch ein inertes Gas und/oder ein Reduktionsgas und/oder ein oxidierendes Gas enthält.

5. Verfahren nach einem der Ansprüche 1 bis 4, dadurch gekennzeichnet, daß das angrenzende Gasgemisch zusätzlich zu der oder den gasförmigen Vorstufe(n) des Siliciums ein inertes Gas und/oder ein Reduktionsgas und gegebenenfalls ein oxidierendes Gas enthält.

6. Verfahren nach einem der Ansprüche 1 bis 5, dadurch gekennzeichnet, daß die Silicium-Vorstufe das Monosilan SiH₄ ist.

7. Verfahren nach einem der Ansprüche 1 bis 6, dadurch gekennzeichnet, daß das Metallsubstrat auf eine Temperatur gebracht wird, die zwischen der Umgebungstemperatur und 400°C liegt.

8. Verfahren nach einem der Ansprüche 1 bis 7, dadurch gekennzeichnet, daß das zu behandelnde Metallsubstrat in Position gegenüber dem Gasauslaß (6) des Geräts (4), gegebenenfalls gegenüber den Gasauslässen mehrerer parallel über die Breite des Substrats angeordneter Geräte und/oder aufeinanderfolgend in Position gegenüber den Gasauslässen mehrerer in Reihe angeordneter Geräte (11,4,12), mittels eines Fördersystems (2) geführt wird, das einen inneren, von einer Verkleidungs-Einheit (3) begrenzten Raum (31) durchquert, der von der umgebenden Atmosphäre isoliert ist, wobei diese Einheit hermetisch mit dem Gerät zusammengeschlossen ist oder das Gerät umschließt.

9. Verfahren nach Anspruch 8 in dessen Verbindung mit Anspruch 3, dadurch gekennzeichnet, daß die in dem Gerät aufgewendete Energie, bezogen auf die Flächeneinheit des Dielektrikums, oberhalb 1 W/cm² und bevorzugt oberhalb 10 W/cm² liegt.

10. Verfahren nach einem der Ansprüche 8 oder 9, dadurch gekennzeichnet, daß eine Zoneneinteilung der Behandlungsatmosphäre, die aufeinanderfolgend auf das zu behandelnde Substrat längs des Förderbands auftrifft, auf folgende Weise durchgeführt wird:
a) wenigstens eines der Geräte zur Bildung von angeregten oder instabilen Gasarten wandelt ein Ausgangsgasgemisch um, das sich von demjenigen unterscheidet, das mittels des vorhergehenden Geräts in dieser Einheit umgewandelt wird, und/oder
b) das angrenzende Gasgemisch, das im Bereich wenigstens eines der Geräte zur Herstellung angeregter oder instabiler Gasarten eingesetzt wird, unterscheidet sich von demjenigen, das im Bereich des vorhergehenden Geräts in dieser Einheit eingesetzt wird.

11. Verfahren nach Anspruch 10, dadurch gekennzeichnet, daß die Schritte a) und b) im Bereich des gleichen Geräts stattfinden.

12. Vorrichtung zur Erzeugung einer Abscheidung eines Silicium enthaltenden Films auf einem Metallsubstrat, die insbesondere zur Ausführung eines beliebigen der Ansprüche 1 bis 11 geeignet ist und die eine Verkleidung (3) aufweist, die einen inneren Raum (31) definiert, der von Mitteln zur Förderung (2) der zu behandelnden Metallsubstrate (1) durchquert wird, von der umgebenden Atmosphäre isoliert ist und mit einem oder mehreren Geräten (11,4,12) zur Herstellung von angeregten oder instabilen Gasarten verbunden ist oder diese umschließt, die in Reihe und/oder parallel angeordnet sind und wenigstens einen röhrenförmigen, eine Achse aufweisenden Gasdurchgang (18) enthalten, der zwischen einer äußeren Elektrode (14) und einer inneren Elektrode (17) gebildet wird, wobei wenigstens eine der Elektroden eine der anderen gegenüberliegende dielektrische Umhüllung (16) aufweist, die Elektroden an eine Hochspannungs- und Hochfrequenz-Quelle angeschlossen sind und die äußere Elektrode (14) das Dielektrikum (16) umgibt und einen Einlaß (20) für das Ausgangsgas und einen Gasaustritt (21) für das Primärgas aufweist, die parallel zur Achse verlängert sind und sich in etwa diametral gegenüberliegen, wobei der Gasaustritt in das Innere dieser Einheit einmündet, die mit wenigstens einem Einspeisungsmittel (9,10,13) für ein angrenzendes Gas, das nicht durch das Gerät oder die Geräte geleitet wurde, ausgestattet ist.

## Claims

1. Process for forming a deposit of a film containing silicon on a metallic substrate (1), according to which use is made of at least one apparatus (11, 4, 12) for forming excited or unstable gaseous species, in which an initial gaseous mixture (7) is converted into a primary gaseous mixture (8), the apparatus being the seat of an electric discharge created between a first electrode (14) and a second electrode (17), which extend in a principal elongated direction, the initial gaseous mixture passing through the discharge transversely to the electrodes and to this principal direction, the primary gaseous mixture (8) which is obtained at the gas outlet (6) of the said apparatus, which includes excited or unstable gaseous species and which is substantially free from electrically charged species forming, with an adjacent gaseous mixture (9, 10) which includes at least one gaseous precursor of silicon and which has not passed through the said apparatus, the gaseous treatment atmosphere (30) which is put into contact with the substrate to produce the deposit.

2. Process according to claim 1, characterized in that the gaseous treatment atmosphere (30) is put into contact with the substrate at a pressure close to atmospheric pressure.

3. Process according to either of claims 1 or 2, characterized in that a layer of dielectric material is deposited on the surface of at least one of the electrodes, facing the other electrode.

4. Process according to one of claims 1 to 3, characterized in that the said initial gaseous mixture includes an inert gas and/or a reducing gas and/or an oxidizing gas.

5. Process according to one of claims 1 to 4, characterized in that the said adjacent gaseous mixture includes, in addition to the gaseous precursor or precursors of silicon, an inert gas and/or a reducing gas and where appropriate an oxidizing gas.

6. Process according to one of claims 1 to 5, characterized in that the gaseous precursor of silicon is monosilane, SiH₄.

7. Process according to one of claims 1 to 6, characterized in that the metallic substrate is brought to a temperature of between ambient temperature and 400°C.

8. Process according to one of claims 1 to 7, characterized in that the metallic substrate to be treated is brought facing the gas outlet (6) of the said apparatus (4), and where appropriate facing the gas outlets of several apparatuses placed in parallel over the width of the substrate and/or successively facing the gas outlets of several apparatuses (11, 4, 12) placed in series, by a conveyer system (2) passing through an inner space (31) delimited by a cowling assembly (3), isolated from the surrounding atmosphere, the said assembly being connected in a leakproof manner to the said apparatus or including the said apparatus.

9. Process according to claim 8, in its association with claim 3, characterized in that the energy used in the said apparatus, reduced to unit surface area of the dielectric, is greater than 1 W/cm², preferably greater than 10 W/cm².

10. Process according to either of claims 8 or 9, characterized in that the treatment atmosphere encountered successively by the substrate to be treated is split into zones along the conveyer, in the following manner :
a) at least one of the apparatuses for forming excited or unstable gaseous species converts an initial gaseous mixture different from that converted by the apparatus preceding it in the said assembly, and/or
b) the adjacent gaseous mixture used in at least one of the said apparatuses for forming excited or unstable gaseous species is different from that used in the apparatus preceding it in the said assembly.

11. Process according to claim 10, characterized in that the steps a) and b) take place in the same apparatus.

12. Device for forming a deposit of a film containing silicon on a metallic substrate, suitable in particular for implementing any one of claims 1 to 11, including a cowling assembly (3) defining an inner space (31) traversed by means (2) for conveying the metallic substrates (1) to be treated, isolated from the surrounding atmosphere, connected in a leakproof manner to or including one or more apparatuses (11, 4, 12) for forming excited or unstable gaseous species, mounted in series and/or in parallel, including at least one tubular gas passage (18) having an axis, formed between an outer electrode (14) and an inner electrode (17), at least one of the electrodes having, facing the other, a dielectric coating (16), the electrodes being connected to a high voltage, high frequency source, the outer electrode (14) surrounding the dielectric (16) and including an elongated initial gas inlet (20) and an elongated primary gas outlet (21), parallel to the axis and substantially diametrically opposite it, the said gas outlet emerging inside the said assembly, which is provided with at least one means (9, 10, 13) for injecting an adjacent gas which has not passed through the said apparatus or apparatuses.
